# EUROPEAN PATENT SPECIFICATION

(11) **EP 0 624 279 B1**
(45) Date of publication and mention of the grant of the patent: **05.03.1997**
(21) Application number: 93903191.0
(22) Date of filing: 28.01.1993
(51) Int. Cl.: H01H 13/70, H03K 17/96

(54) **A TOUCH RESPONSIVE CONTROL PANEL**
AUF BERÜHRUNG ANSPRECHENDES BEDIENUNGSFELD
TABLEAU DE COMMANDE A EFFLEUREMENT

(30) Priority: 28.01.1992 DK 100/92
(43) Date of publication of application: 17.11.1994
(73) Proprietor: NICOLAISEN, Mogens, DK-8900 Randers (DK)
(72) Inventor: NICOLAISEN, Mogens, DK-8900 Randers (DK)
(74) Representative: Skoett-Jensen, Knud
(86) International application number: PCT/DK93/00034
(87) International publication number: WO 93/15518

(56) References cited:
- EP-A- 0 054 306
- WO-A-89/02135
- DE-A- 2 728 188
- DE-A- 3 107 400

## Description

The present invention concerns a touch sensitive control panel of the kind comprising a front plate preferably in a dielectric material such as glass, and electrodes disposed on its reverse side together with with electronic circuits where the front plate carries markings that indicate touch areas, whereby a touch by a finger gives such an operative coupling to the respective electrodes disposed on the reverse side that the panel unit may give off selective control signals by means of the electronic circuits. Such panel units, as known for instance from DE-A-27 28 188, or elements are increasingly used as control panels in various kinds of electrical and electronic equipment because they may advantageously replace panels with mounted mechanically acting switches or rotary or pushbutton activated elements in that a light touch upon a selected area may effect the desired function, such as a start or stop function or an ascending or descending control function without any use of mechanical action. These units function by capacitive coupling.

In particular because this kind of control panel are known per se the general advantages of using them will not be discussed in detail here. It may be more relevant to note that the control panels according to the novel technology are predominantly manufactured in specialist establishments because it is no longer a simple mounting of ready-made special switches and controllers but the manufacture of a new type of product which comprises both the panel plate and at least the most necessary electronic circuitry.

It has, however, been possible to prepare a kind of intermediate stage where the manufacture of the panel plate itself has been a specialist task whereas the electronic circuitry might be put on a conventional printed circuit board which could be prepared with suitable contact means for establishing contact with specific electrode areas on the reverse of the front plate. These defined areas are typically made as a coating of graphite powder which by a suitable technique has been fixed reliably to the reverse of the front plate so that the electrode areas thus created have a suitable extent with a well-defined position and are easily accessible for establishing contact with projecting contact elements on the printed circuit board disposed behind it, as these elements only need to abut the said coatings in a fairly uncritical fashion somewhere on their extent.

It has, however, been shown in practice that there may still be considerable contact problems because mechanical fitting of the relevant contact parts is relied upon. Possibly contaminating factors may make the establishment of an effective connection doubtful.

According to the present invention, as defined in claim 1, the said printed circuit board is dispensed with entirely in that one additionally places the relevant electronic components directly on the panel plate, to which they are fixed by e.g. cementing or to the electrode areas fixed thereon.

The important thing is that by using the panel plate for carrying both the electrode areas and the requisite electronic components one may not only dispense with the circuit board but a totally integrated solution is obtained whereby the manufacturing facility may construct the units with high precision and thereby produce units with a very high degree of precision in an optimized manner and thereby produce units which distinguish themselves by a high degree of functional reliability.

The panel plate may in this connection have any size or shape, including an arched or vaulted shape and the unit may have a minimal thickness. The requisite components may be fastened by surface mounting (soldering) or cementing to the electrode areas or to other conductive layers on the panel plate or by cementing or casting in place of the housing of the components to the support.

The panel plate may to a certain extent be used as a printed circuit board, i.e. with fixed conductive strips between different terminal areas but the plate may also be used in such a way that it is supplied with a shielding coating around and between the operative electrode areas; thereby an EMC shielding of high quality may be obtained, and the shielding coating may well be used for fixing components which are not electrically connected to the shield.

In connection with the integrated solution mentioned coatings on the panel plate are in focus, and it is a distinct possibility that the coating itself may be differentiated to create different components such as resistors in a coating paste which has been laid out. The coating may play an active rôle also in connection with obtaining desired temperature compensation.

An embodiment of the invention is shown in the drawing, in which
Fig. 1 is a perspective representation of a panel element according to the invention seen from the front,
Fig. 2 is the same seen from the back, and
Fig. 3 is a section through the same.

The element shown which is based on capacitive touch coupling has a glass plate 2 on the front of which are marked touch areas 4, while there may be window areas 6 in front of display units disposed behind the panel.

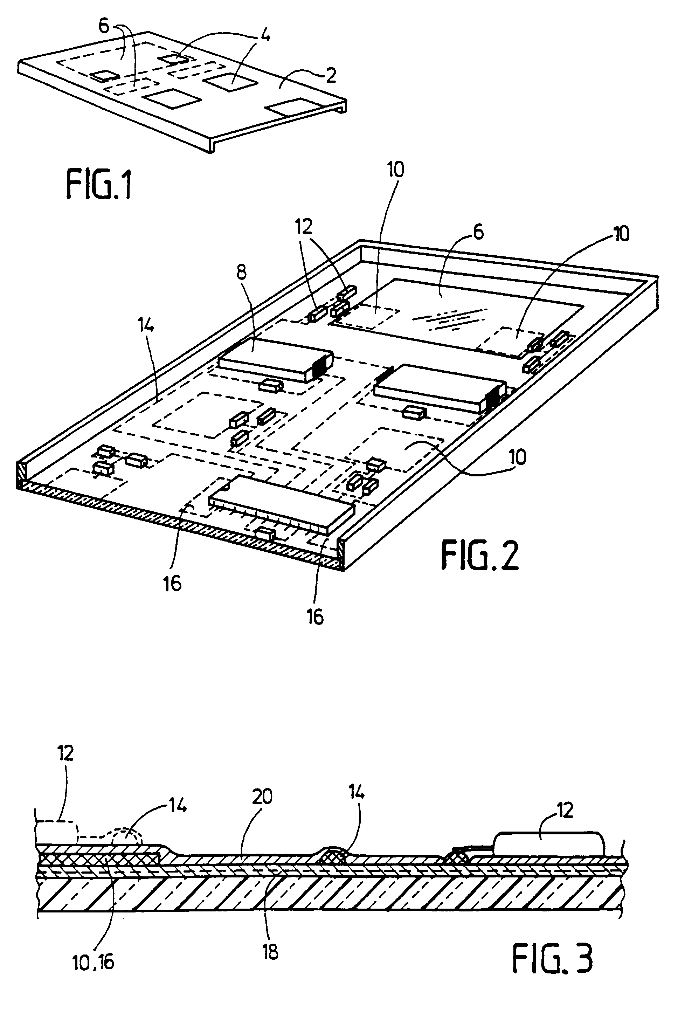

As shown in Fig. 2 such a window area 6 may be open toward the rear for showing a display which is independent of the plate while other window areas may be covered with display units 8 which e.g. by cementing may be fastened directly to the glass plate.

Behind the areas 4 there are disposed conducting coating areas 10 on the reverse side which by means of suitable termination are connected to electronic components 12 which are fastened directly to the plate 2. Component leads or wires may be connected by soldering or cementing directly to the areas 10 or to conductor strips 14 which are connected thereto and the components may be mutually connected either by their own wires or by means of printed conductors. The connector for the whole element may be a multiple connector which is cemented thereto or even by wires leading therefrom.

On the areas outside the areas 10 there may be a conductive shielding coating 16, see Figs. 2 and 3, onto which where there may be fitted both components 12 and conductive strips 14. It is even possible to apply conductive coatings of a transparent type (ITO), whereby also transparent plate sections 6 may be shielded or where transparent, active coating areas 10 may be established.

In Fig. 3 it is shown that a so-called undercoat layer 18 may be applied directly to the glass plate. It may not only provide the base colour of the glass, but equally - as known from printed circuit technology - but also act as a suitable base for a subsequent printing of the conductive strings 14 and areas 10 which may consist of a silver compound applied by screen printing. On top of this there is applied an overcoat layer 20 which is generally covering, however not at the relevant soldering points.

It is a possibility to print conductive strips on top of the layer 20 whereby a lower shielding layer 16 may extend unbroken across large parts of the whole unit.

Through the use of components directly mounted on the panel plate it will be particularly simple to make use of a an attachment which may deliver a discrete signal of acknowledgement of an operation performed on the panel, in that a hammer unit may act on the panel plate with an impulse for each push on the panel plate, which the user may perceive by the touching of the panel by the finger or by a corresponding emission of a sound.

## Claims

1. A capacitive touch sensitive control panel of the kind comprising: a front plate (2) preferably in a dielectric material such as glass, markings (4) indicating operative touch areas, electrodes or sensors (10) with corresponding electronic circuitry disposed at the reverse side of the front plate which by touching the plate with the finger and a thereby established operative coupling to a selected electrode or sensor (10) may give off a selective control signal, **characterized in** the combination of the electrodes or sensors (10) being directly formed on or fixed only to the reverse of the panel plate (2) and that also relevant parts and components of the electronic equipment (12) are mechanically fastened to the same reverse side without use of a separate carrier plate.

2. A touch sensitive input panel according to claim 1, **characterized in** that the components are fastened by Surface Mounting, cementing or casting.

3. A touch sensitive input panel according to claim 1, **characterized in** that the reverse side of the panel plate (2) is further prepared with conductive field- or strip areas (10,16) for creating respective shield or connection areas.

4. A touch sensitive input panel according to claim 1, **characterized in** that one of the components directly fixed to the reverse side is a hammer device for delivery of mechanical acknowledgement impulses to the panel plate (2).

## Patentansprüche

1. Eine kapazitive berührungsempfindliche Kontrolltafel, umfassend: Eine Frontplatte (2), vorzugsweise aus einem dielektrischen Material wie Glas, Markierungen (4), die die wirksamen Berührungsflächen anzeigen, Elektroden oder Sensoren (10) mit entsprechender elektronischer Schaltung, die an der Rückseite der Frontplatte angeordnet sind, die durch Berührung der Platte mit dem Finger und eine dadurch aufgebaute Wirkverbindung gegenüber einer ausgewählten Elektrode oder einen Sensor (10), ein selektives Kontrollsignal abgeben können, **dadurch gekennzeichnet,** daß die Kombination der Elektroden oder Sensoren (10) direkt auf der Rückseite der Schalttafelplatte (2) ausgebildet oder nur daran befestigt ist und daß auch relevante Teile und Komponenten der elektronischen Ausrüstung (12) mechanisch an derselben Rückseite ohne Nutzung einer separaten Trägerplatte befestigt sind.

2. Ein berührungsempfindliches Eingabepult nach Anspruch 1, **dadurch gekennzeichnet,** daß die Komponenten durch Oberflächenanbringung, Kleben oder Gießen befestigt sind.

3. Ein berührungsempfindliches Eingabepult nach Anspruch 1, **dadurch gekennzeichnet,** daß die Rückseite der Schalttafelplate (2) weiterhin mit leitenden Feld- oder Streifenbereichen (10, 16) versehen ist, um entsprechende Abschirm- oder Verbindungsbereiche zu schaffen.

4. Ein berührungsempfindliches Eingabepult nach Anspruch 1, **dadurch gekennzeichnet,** daß eine der direkt an der Rückseite befestigten Komponenten eine Hammereinrichtung zum Übermitteln mechanischer Rückmeldungs-Impulse an die Schalttafelplatte (2) ist.

## Revendications

1. Pupitre à touches sensitives capacitives, du type comprenant : une plaque avant (2) de préférence en une matière diélectrique telle que du verre, des repères (4) indiquant des zones fonctionnelles des touches, des électrodes ou capteurs (10) à circuit électronique correspondant disposés du coté arrière de la plaque avant, qui, en touchant la plaque avec le doigt et un couplage fonctionnel ainsi établi vers une électrode ou capteur (10) choisi, peut émettre un signal de commande sélectif,
caractérisé dans la combinaison des électrodes ou capteurs (10) qui sont directement formés sur ou fixés seulement à l'arrière du pupitre (2) et en ce que également des pièces ou composants concernés de l'équipement électronique (12) sont fixés mécaniquement du même côté arrière sans l'utilisation d'une plaque de support séparée.

2. Pupitre à touches sensitives selon la revendication 1,
caractérisé en ce que les composants sont fixés par montage de surfaces, collage ou moulage.

3. Pupitre à touches sensitives selon la revendication 1,
caractérisé en ce que le côté arrière du pupitre (2) est de plus préparé avec des zones à bande ou secteur conducteur (10,16) pour créer des zones de connexion ou à blindage respectives.

4. Pupitre à touches sensitives selon la revendication 1,
caractérisé en ce qu'un des composants fixé directement au côté arrière est un dispositif à marteau pour fournir des impulsions mécaniques de réception au pupitre (2).
